Europäisches Patentamt

European Patent Office

Office européen des brevets

(19)

(11) Publication number: **0 173 558**
A2

(12)

# EUROPEAN PATENT APPLICATION

(21) Application number: 85306086.1

(22) Date of filing: 28.08.85

(51) Int. Cl.⁴: **H 01 L 29/20, H 01 L 21/302**

(30) Priority: 29.08.84 JP 178315/84

(43) Date of publication of application: 05.03.86
Bulletin 86/10

(84) Designated Contracting States: **DE FR GB**

(71) Applicant: **HITACHI, LTD., 6, Kanda Surugadai 4-chome
Chiyoda-ku, Tokyo 100 (JP)**

(72) Inventor: **Morioka, Makoto, 2196-64 Hirai Hinodemachi,
Nishitama-gun Tokyo (JP)**
Inventor: **Mori, Mitsuhiro, 1473 Jousuihoncho,
Kodaira-shi Tokyo (JP)**
Inventor: **Katayama, Yoshifumi, 1303-9 Shimotomi,
Tokorozawa-shi Saitama-ken (JP)**
Inventor: **Shiraki, Yasuhiro, 1-106, 3-26-1 Hirayama,
Hino-shi Tokyo (JP)**
Inventor: **Usagawa, Toshiyuki, Hitachi
Dai 4 Kyoshin-ryo 4-14-6 Nishikoigakubo, Kokubunji-shi
Tokyo (JP)**

(74) Representative: **Paget, Hugh Charles Edward et al,
MEWBURN ELLIS & CO. 2/3 Cursitor Street, London
EC4A 1BQ (GB)**

(54) **Mesa structure comprising a compound semiconductor.**

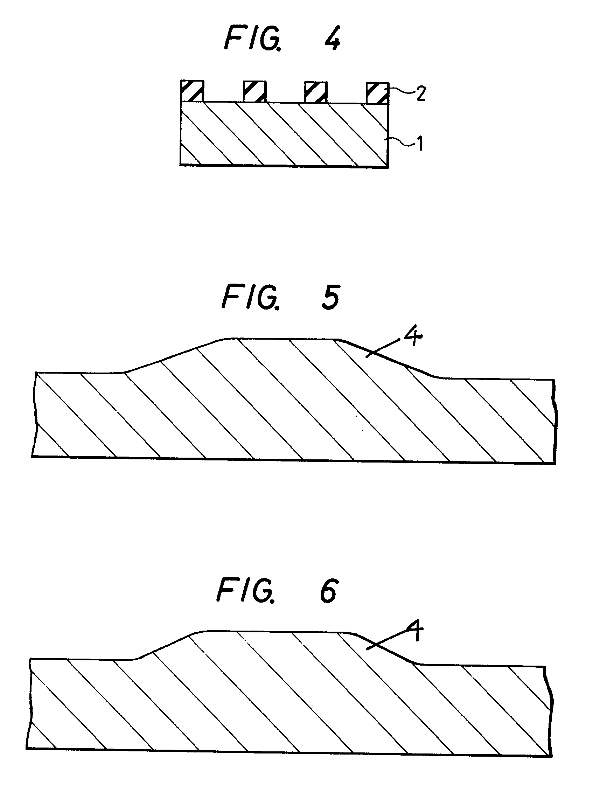

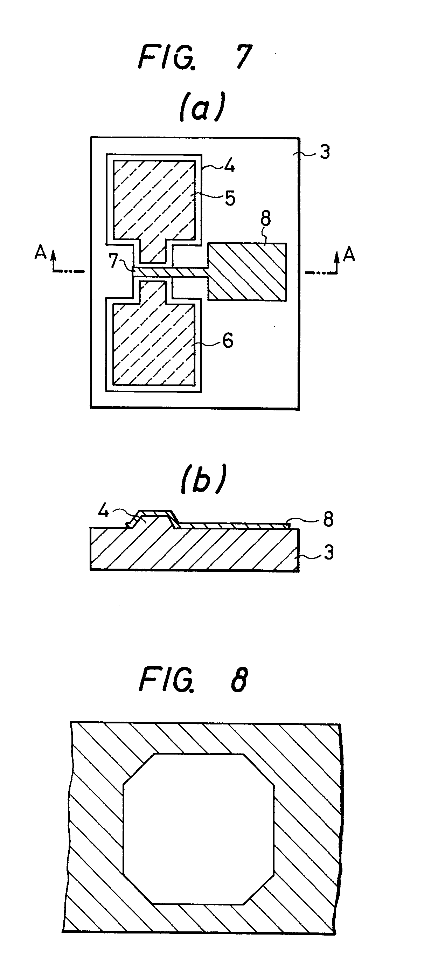

(57) A mesa structure in which all of the sloped surfaces of the mesa structure composed of a GaAs compound semiconductor are inclined outwardly from the top face of the mesa structure e.g. in both the (110) and ($\overline{1}$10) directions (Figs. 5 and 6). The mesa structure can be obtained by etching using a mixed solution of $NH_4OH$, $H_2O_2$ and $H_2O$ by way of a desired mask. By utilizing the mesa structure having the main surface at the (100) plane to a FET or like other semiconductor device, disconnection of wirings can be prevented.

EP 0 173 558 A2

0173558

## Mesa structure comprising a compound semiconductor

This invention relates to a mesa structure comprising a compound semiconductor, particularly, composed of GaAs/GaAlAs type material. Such a mesa structure is extremely valuable for use in the production of semiconductor devices composed of GaAs/GaAlAs type material.

In the etching of compound semiconductors, particularly, for the formation of mesa, recess or like other configuration, etching speed differs depending on the direction of the plane of crystal to be etched. Accordingly, this results in a drawback that while a forward mesa structure having a slope with an angle of greater than 90 degree between the bottom face and the side face upon mesa etching is formed along a certain direction, a reversed mesa structure having an overhang shape with an angle of equal to or less than 90 degree between the bottom face and the side face upon mesa etching is formed in the direction perpendicular to the above-mentioned direction.

The foregoing fact is reported in the article entitled : "A Chemical Etchant for the Selective Removal of GaAs Through $SiO_2$ Masks" written by J.J. Gannon and C. J.

Nuese, contained in J. Electrochem. Soc. : vol. 121, No. 9, pp 1215-1219 (1974).

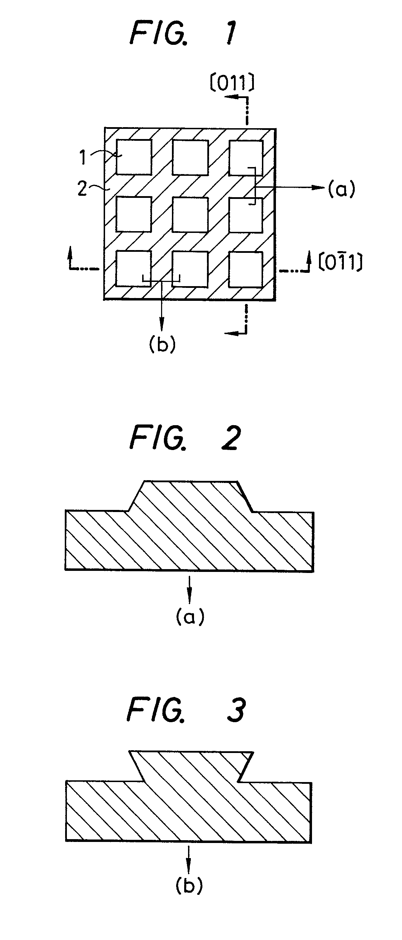

This article reports, with reference to its Figure 4, the result of forming an etching mask 2 having square apertures arranged in a 3 x 3 matrix with $SiO_2$ (as shown in Figure 1 of the present drawings) on the (100) plane 1 of a GaAs surface and performing etching using a solution of 0.3 N $NH_4OH$:0.1 N $H_2O_2$ prepared by mixing 20 ml of $Nh_4OH$, 7 ml of 30% $H_2O_2$ (stabilized) and 973 ml of $H_2O$. The cross section taken along line a in Figure 1 shows a so-called forward mesa configuration as shown in Figure 2, while the cross section taken along line b in Figure 1 shows the reversed mesa configuration as shown in Figure 3.

Laminating a second semiconductor, or forming a metal wiring, an insulating layer, etc. on such a structure, is easy with the structure shown in Figure 2. On the other hand, with the structure shown in Figure 3, disconnections may occur at the steps or cavities may be left on the inside of an overhang configuration. Thus, for a fine structure such as in LSI, one must avoid wiring in the direction having the cross sectional structure shown in Figure 3. Thus, flexibility of design of the device is significantly restricted.

0173558

-3-

SUMMARY OF THE INVENTION

This invention provides an advantageous mesa structure having a single layer (including that of single crystal) or plural layers composed of a compound semiconductor, particularly of $Ga_{1-x}Al_xAs$ ($0 \leq x < 1$), in which all of the sloped surfaces of the mesa structure are inclined outwardly from the top surface of the mesa structure. In this specification, the surface at the top of the mesa structure is hereinafter referred to as the top face.

The above-mentioned mesa structure can be obtained by etching the (100) plane of the crystal with the mixed solution of $NH_4OH$, $H_2O_2$ and $H_2O$ by way of a desired mask. In this case, conditioning of the etching solution is important.

BRIEF DESCRIPTION OF THE DRAWINGS

Figure 1 is a plan view of the etching mask,

Figure 2 and Figure 3 are cross sectional vies of the mesa structure in the direction of $(0\bar{1}1)$ and (011) plane formed by ordinary etching of GaAs crystals,

Figure 4 is a cross sectional view illustrating a mask on a substrate,

Figure 5 and Figure 6 are cross sectional views of the mesa structures according to this invention,

Figure 7 is a view illustrating an embodiment using the present mesa structure in the operating region of a field effect transistor, and

Figure 8 is a plan view illustrating another aperture shape of an etching mask.

In a III - V (group) compound semiconductor such as GaAs, the (100) plane is ordinarily used for the device. The production of a mesa structure using the (100) plane as the main surface will now be explained.

First, a GaAs wafer 1 having the main surface at the (100) plane is prepared and an etching mask 2 having a plane pattern as shown in Figure 1 is formed on the main surface. An etching mask with square apertures of 1 mm side is prepared by depositing a $SiO_2$ film of 0.3 μm thickness at 400°C using a well-known CVD process (Chemical Vapor Deposition process). Figure 4 is a cross sectional view showing this state.

In patterning the square mask, one side is aligned in parallel with the cleavage direction of the GaAs wafer. The GaAs wafer having the thus formed square $SiO_2$ mask is etched by using an etching solution comprising the composition as described below.

The composition and the method of preparing the etching solution is as follows:

Two types of mixed solutions of:

(1)     $H_2O$ : $NH_4OH$ = 400 cc : 10 cc

(2)     $H_2O$ : $[H_2O_2]$ = 80 cc : 20 cc are prepared at first and 10 cc of the solution (2)
is then mixed into the solution (1) for use.  Etching
is carried out at a solution temperature of 24°C.
Etching is carried out for 15 minutes and to an etching
depth of about 1.6 μm.

$[H_2O_2]$ as described above means a commercial
30% (by volume) aqueous solution of $H_2O_2$, so that the
solution has the composition 0.177N $NH_4OH$ : 0.0476N $H_2O_2$
(3.72 : 1).  The purpose of this process can equally
be attained by incorporating $[H_2O_2]$ within a range
from 5 cc to 25 cc to the entire 100 cc volume, giving
a range of compositions of the etching solution of
0.177N $NH_4OH$ : 0.0117 to 0.0548N $H_2O_2$, i.e. in the
range 14.5 : 1 to 3.22 : 1.

Figures 5 and 6 are views showing the cross
sectional mesa structures obtained by use of such
solutions using a GaAs wafer having a direction of
plane (100).  Figure 5 is an etching cross section
in the direction of (110) plane, that is, the cross
section through a mesa 4 in the conventional forward
mesa direction, while Figure 6 is an etching cross
section in the direction ($1\bar{1}0$) plane, that is, the
cross section of a so-called conventional reversed
mesa direction, each of which shows forward mesa structures.
The angle relative to the wafer surface is about 18
degrees in the direction of the (110) plane and about 25 degree in the direction of the ($1\bar{1}0$) plane.

Explanation will then be made for an example in which the mesa structure according to this invention is applied to the operation region of a field effect transistor. The mesa structure according to this invention is also applicable to LED, LD or like other device in addition to the field effect transistor.

Figure 7 shows a GaAs FET (field effect transistor) prepared by using the mesa structure according to this invention. In the figure, (a) shows the plane pattern and (b) shows the cross sectional structure along line A-A in Figure 7(a). This FET comprises a wafer 3 having an operation layer doped with $\sim 2 \times 10^{17} \text{cm}^{-3}$ Te epitaxially grown to a thickness of 0. 5 μm on a semi-insulating GaAs substrate. This FET is prepared by the steps as described below. (1) The epitaxial grown layer at the operating region portion of the FET is etched into a mesa configuration 4 for the inter-device separation. (2) Ohmic electrodes 5, 6 each composed of Au/Ni/AuGe are formed by the tecnics of photoetching, vapor deposition and alloying. A pair of electrodes 5, 6 form a source and a drain. (3) In the same manner, a gate electrode 8 is prepared by using photoetching and vapor deposition tecnics.

In the preparation of this FET, the mesa structure is formed by using the $NH_4OH$ type etching solution as described above. Since each of the portions of the FET can be prepared by the known steps employed so far, except for forming the operation region of the FET into the mesa structure 4, explanations for the details of the preparation steps are omitted. Since the requirement for previously determining the aligning direction either to (110) or ($1\overline{1}0$) in the photolithography can thus be eliminated, as well as the work for confirming the aligning direction, i. e., the work for confirming that the gate lead out portion 7 is always in the forward mesa direction is no more necessary, the working steps can be shortened and occurrence of defects due to the erroneous aligning in the direction can completely be eliminated. Furthermore, since the angle between the cross sectional side of the mesa structure and the bottom face is less acute than ~ 57° in the conventional forward mesa structure shown, for example, in the cited literature, if etching is applied so as to obtain a deep mesa shape for ensuring the inter-device separation, for example, to ~ 1 µm, which is twice as deep as the film thickness of the epitaxial grown layer, there is no worry that wirings (0.3 - 0.4 µm) may be disconnected at the portion of the step 7. This can provide an extremely great flexibility to the process to thereby simplify the process for producing the device.

Accordingly, by the use of the cross sectional mesa structure according to this invention, production of a compound semiconductor, particularly, GaAs or GaAlAs type device can be much facilitated as described below.

(1) Although it has been necessary that the patterning be made such that the wiring direction is aligned with the forward mesa direction upon photolithography, it can now be patterned optionally in any of cleavage directions and the industrial working time efficiency can significantly be improved. (2) In the production of IC tips or the likes, since no reversed mesa structure is present after applying the mesa etching for the inter-device connection separation, the degree of freedom for the inter-device wirings can significantly be improved and the problems such as wire disconnections in the mesa edges can be overcome. (3) In a case where a pn junction is exposed at the mesa end and a protective oxide film is formed therefor, since the step coverage is satisfactory there are no such problems that the protective oxide film becomes thinner or can not be deposited as experienced in the conventional reversed mesa direction, whereby the improvement can be obtained for the device characteristics.

Further, when a $SiO_2$ mask having an octahedral shape as shown in Figure 8 is used, a predetermined forward mesa structure could be obtained for each of the sides. It will be apparent that the mask shape is not restricted only to those exemplified above but may be circular or any other shape.

CLAIMS

1.      A mesa structure composed of a compound semiconductor having a single layer or plural layers of a compound semiconductor comprising at least one element selected from the group consisting of gallium - arsenic and gallium - aluminum - arsenic, with sloped surfaces leading from the top of the mesa characterised in that all the sloped surfaces of the mesa structure are inclined outwardly from the top face of said mesa structure.

2.      The mesa structure as defined in claim 1, wherein the main surface of the single layer or of the plural layers of the compound semiconductor comprises the (100) plane.

3.      The mesa structure as defined in claim 2, wherein the shape of the top face of the mesa structure is rectangular.

4.      The mesa structure as defined in claim 2, wherein the shape of the top face of the mesa structure is circular.

5.      The mesa structure as defined in claim 2, wherein the angle of the sloped surface relative to the top face is about 18 degrees in the direction of the (110) plane.

6.      The mesa structure as defined in claim 2, wherein the angle of the sloped surface relative to the top face is about 25 degrees in the direction of the $(1\bar{1}0)$ plane.

7.    The mesa structure composed of a compound semiconductor as defined in claim 2, wherein the mesa structure is obtained by etching the (100) plane with a mixed solution of $NH_4OH$, $H_2O_2$ and $H_2O$ by way of a desired mask.

8.    A method of forming a mesa structure as defined in any one of the preceding claims by etching with an aqueous solution of $NH_4OH$ and $H_2O_2$ through a mask, characterized in that the etching solution has a composition wherein the ratio $NH_4OH:H_2O_2$ is 14.5 to 3.22:1.

9.    A method according to claim 8 wherein the concentration of the $NH_4OH$ is not greater than 0.2 N.

## FIG. 1

[011]

1
2

(a)

[01̄1]

(b)

## FIG. 2

(a)

## FIG. 3

(b)

## FIG. 4

## FIG. 5

## FIG. 6

## FIG. 7

### (a)

### (b)

## FIG. 8